# EUROPEAN PATENT APPLICATION

(11) **EP 4 657 219 A1**
(43) Date of publication of application: **03.12.2025**
(21) Application number: 25178104.3
(22) Date of filing: 22.05.2025
(51) Int. Cl.: G06F 3/041, G06F 3/044, H10K 59/40

(54) **DISPLAY DEVICE AND ELECTRONIC APPARATUS INCLUDING THE SAME**

(30) Priority: 30.05.2024 KR 20240070969
(71) Applicant: Samsung Display Co., Ltd., Yongin-si, Gyeonggi-do 17113 (KR)
(72) Inventor: PARK, Yong-Hwan, Giheung-Gu, Yongin-si, Gyeonggi-Do 17113 (KR); KO, Gyung-Min, Giheung-Gu, Yongin-si, Gyeonggi-Do 17113 (KR); KIM, Juyeon, Giheung-Gu, Yongin-si, Gyeonggi-Do 17113 (KR); LEE, Seongjun, Giheung-Gu, Yongin-si, Gyeonggi-Do 17113 (KR)
(74) Representative: Dr. Weitzel & Partner

(57) **Abstract**

A display device includes a display panel including a plurality of unit pixels and an input sensor. The input sensor includes a first sensor conductive layer, a first sensor insulating layer, and a second sensor conductive layer. At least one of the first and second sensor conductive layers is provided with a mesh opening defined therethrough, each of the unit pixels includes first, second, and third light emitting areas respectively emitting first, second, and third color lights, the first light emitting area of the first unit pixel and the second light emitting area of the second unit pixel are alternately arranged with each other in a first direction, and the second light emitting area of the first unit pixel and the first light emitting area of the second unit pixel are alternately arranged with each other in the first direction.

## Description

### BACKGROUND

### 1. Field

The present invention relates to a display device including a display panel and an input sensor and to an electronic apparatus including the display device.

### 2. Description of Related Art

Multimedia electronic devices, such as televisions, mobile phones, tablet computers, navigation units, and game units, include a display device to provide users with images through a display screen. The display device provides a touch-based input method allowing users to relatively easily and intuitively input information or commands.

The display device includes a display panel generating the images and an input sensor sensing a user's touch. The input sensor includes a conductor sensing an external input.

The above information disclosed in this Background section is only for enhancement of understanding of the background and therefore the information discussed in this Background section does not necessarily constitute prior art.

### SUMMARY

Aspects of some embodiments of the present invention include a display device with relatively improved display quality, relatively improved touch sensing quality, and a relatively high resolution.

Aspects of some embodiments of the present invention include an electronic apparatus including the display device.

The present invention is defined by the features of independent claim 1. Preferred embodiments are disclosed in the dependent claims and the description.

Aspects of some embodiments of the present invention include a display device including a display panel including a plurality of unit pixels including a first unit pixel and a second unit pixel alternately arranged with the first unit pixel in a first direction and an input sensor on the display panel. According to some embodiments, the input sensor includes a first sensor conductive layer on the display panel, a first sensor insulating layer on the first sensor conductive layer, and a second sensor conductive layer on the first sensor insulating layer. According to some embodiments, at least one of the first and second sensor conductive layers is provided with a mesh opening defined therethrough, each of the unit pixels includes a first light emitting area emitting a first color light, a second light emitting area emitting a second color light, and a third light emitting area emitting a third color light, the first light emitting area of the first unit pixel and the second light emitting area of the second unit pixel are alternately arranged with each other in the first direction, and the second light emitting area of the first unit pixel and the first light emitting area of the second unit pixel are alternately arranged with each other in the first direction.

According to some embodiments, the first light emitting area of the first unit pixel and the second light emitting area of the second unit pixel are alternately arranged with each other with the third light emitting area interposed therebetween, and the second light emitting area of the first unit pixel and the first light emitting area of the second unit pixel are alternately arranged with each other with the third light emitting area interposed therebetween.

According to some embodiments, the first light emitting area is spaced apart from the second light emitting area in a second direction perpendicular to the first direction within the first unit pixel, the third light emitting area is spaced apart from the first and second light emitting areas in the first direction within the first unit pixel, the first light emitting area is spaced apart from the second light emitting area in a direction opposite to the second direction within the second unit pixel, and the third light emitting area is spaced apart from the first and second light emitting areas in the first direction within the second unit pixel.

According to some embodiments, the display panel further includes a third unit pixel alternately arranged with the first unit pixel in the second direction perpendicular to the first direction and a fourth unit pixel alternately arranged with the third unit pixel in the first direction, the first light emitting area of the third unit pixel and the second light emitting area of the fourth unit pixel are alternately arranged with each other in the first direction, and the second light emitting area of the third unit pixel and the first light emitting area of the fourth unit pixel are alternately arranged with each other in the first direction.

According to some embodiments, the first light emitting area of the third unit pixel and the second light emitting area of the fourth unit pixel are alternately arranged with each other with the third light emitting area interposed therebetween, and the second light emitting area of the third unit pixel and the first light emitting area of the fourth unit pixel are alternately arranged with each other with the third light emitting area interposed therebetween.

According to some embodiments, the first light emitting area is spaced apart from the second light emitting area in the second direction perpendicular to the first direction within the third unit pixel, the third light emitting area is spaced apart from the first and second light emitting areas in the first direction within the third unit pixel, the first light emitting area is spaced apart from the second light emitting area in the direction opposite to the second direction within the fourth unit pixel, and the third light emitting area is spaced apart from the first and second light emitting areas in the first direction within the fourth unit pixel.

According to some embodiments, a distance between the third light emitting area of the first unit pixel and the third light emitting area of the third unit pixel is different from a distance between the third light emitting area of the second unit pixel and the third light emitting area of the fourth unit pixel.

According to some embodiments, a distance between the third light emitting area of the first unit pixel and the third light emitting area of the third unit pixel is equal to a distance between the third light emitting area of the second unit pixel and the third light emitting area of the fourth unit pixel.

According to some embodiments, the second sensor conductive layer is provided with the mesh opening, the second sensor conductive layer includes a mesh pattern defining the mesh opening, the mesh pattern includes a first line portion extending in the first direction and a second line portion extending in the second direction perpendicular to the first direction, and the first line portion is between the first unit pixel and the third unit pixel and between the second unit pixel and the fourth unit pixel when viewed in a plane.

According to some embodiments, a width of the first line portion and a width of the second line portion are not constant.

According to some embodiments, the second sensor conductive layer is provided with the mesh opening, the second sensor conductive layer includes a mesh pattern defining the mesh opening, the mesh pattern includes a first line portion extending in the first direction and a second line portion extending in the second direction perpendicular to the first direction, the second line portion includes a second-first line portion and a second-second line portion alternately arranged with the second-first line portion in the first direction, the second-first line portion is at an edge of at least one of the first, second, third, and fourth unit pixels when viewed in the plane, and the second-second line portion crosses over at least one of the first, second, third, and fourth unit pixels when viewed in the plane.

According to some embodiments, the first sensor conductive layer includes an auxiliary mesh pattern, and the auxiliary mesh pattern surrounds each of the first, second, and third light emitting areas when viewed in the plane.

Aspects of some embodiments of the present invention include a display device including a display panel including a plurality of light emitting areas including a first light emitting area emitting a first color light, a second light emitting area emitting a second color light, and a third light emitting area emitting a third color light, and an input sensor on the display panel. According to some embodiments, the input sensor includes a first sensor conductive layer on the display panel, a first sensor insulating layer on the first sensor conductive layer, and a second sensor conductive layer on the first sensor insulating layer. According to some embodiments, at least one of the first and second sensor conductive layers is provided with a mesh opening defined therethrough, each of the first and second light emitting areas is alternately arranged with the third light emitting area in a first direction, the first light emitting area and the second light emitting area are alternately arranged with each other in a second direction perpendicular to the first direction, and the second light emitting area is arranged in a third direction intersecting each of the first and second directions on a plane defined by the first and second directions with the third light emitting area interposed therebetween.

According to some embodiments, the first light emitting area is arranged in a fourth direction intersecting each of the first, second, and third directions on the plane defined by the first and second directions with the third light emitting area interposed therebetween.

According to some embodiments, a distance between one third light emitting area and a third light emitting area adjacent to the one third light emitting area in the second direction is different from a distance between another third light emitting area adjacent to the one third light emitting area in the first direction and a third light emitting area adjacent to the another third light emitting area in the second direction.

According to some embodiments, a distance between one third light emitting area and a third light emitting area adjacent to the one third light emitting area in the second direction is equal to a distance between another third light emitting area adjacent to the one third light emitting area in the first direction and a third light emitting area adjacent to the another third light emitting area in the second direction.

According to some embodiments, the second sensor conductive layer is provided with the mesh opening, and the mesh opening overlaps at least four light emitting areas among the light emitting areas when viewed in the plane.

According to some embodiments, the second sensor conductive layer includes a first mesh opening and a second mesh opening alternately arranged with the first mesh opening in the first direction, the first mesh opening overlaps two first light emitting areas, two second light emitting areas, and one third light emitting area when viewed in the plane, and the second mesh opening overlaps one first light emitting area, one second light emitting area, and two third light emitting areas when viewed in the plane.

According to some embodiments, a mesh pattern defining the mesh opening has a width that is not constant.

According to some embodiments, the first sensor conductive layer includes an auxiliary mesh pattern, and the auxiliary mesh pattern surrounds each of the light emitting areas when viewed in the plane.

Aspects of some embodiments of the present invention include an electronic apparatus including a display device including an active area and a peripheral area adjacent to the active area and a window on the display device. According to some embodiments, the display device includes a display panel including a plurality of unit pixels including a first unit pixel and a second unit pixel alternately arranged with the first unit pixel in a first direction and in the active area, and an input sensor on the display panel. According to some embodiments, the input sensor includes a first sensor conductive layer on the display panel, a first sensor insulating layer on the first sensor conductive layer, and a second sensor conductive layer on the first sensor insulating layer. According to some embodiments, at least one of the first and second sensor conductive layers is provided with a mesh opening defined therethrough, each of the unit pixels includes a first light emitting area emitting a first color light, a second light emitting area emitting a second color light, and a third light emitting area emitting a third color light, the first light emitting area of the first unit pixel and the second light emitting area of the second unit pixel are alternately arranged with each other in the first direction, the second light emitting area of the first unit pixel and the first light emitting area of the second unit pixel are alternately arranged with each other in the first direction, the first light emitting area of the first unit pixel and the second light emitting area of the second unit pixel are alternately arranged with each other with the third light emitting area interposed therebetween, and the second light emitting area of the first unit pixel and the first light emitting area of the second unit pixel are alternately arranged with each other with the third light emitting area interposed therebetween.

According to some embodiments, the display device of the electronic apparatus includes the display panel with the arrangement of pixels, which may enable relatively reducing a difference in a degree of light blocking according to the viewing angle (luminance versus angle) between lights of different colors, and an input sensor with the arrangement of metal wiring. Thus, a high-resolution display device with excellent display and sensing characteristics and the electronic apparatus including the display device may be provided.

### BRIEF DESCRIPTION OF THE DRAWINGS

The above and other aspects of some embodiments of the present invention will become readily apparent by reference to the following detailed description when considered in conjunction with the accompanying drawings wherein:
FIG. 1 is an assembled perspective view of an electronic apparatus according to some embodiments of the present invention;
FIG. 2 is an exploded perspective view of an electronic apparatus according to some embodiments of the present invention;
FIGS. 3A and 3B are cross-sectional views of electronic apparatuses taken along a line I-I' of FIG. 2;
FIGS. 4A to 4C are cross-sectional views of display devices according to some embodiments of the present invention;
FIG. 5 is a plan view of a display panel according to some embodiments of the present invention;
FIG. 6 is a plan view of an input sensor according to some embodiments of the present invention; and
FIGS. 7, 8A, 8B, 9A, and 9B are enlarged plan views of active areas according to some embodiments of the present invention.

### DETAILED DESCRIPTION

Aspects of some embodiments of the present invention may be variously modified and realized in many different forms, and thus aspects of some embodiments of the present invention are illustrated in the drawings and described in detail hereinbelow. However, embodiments according to the present invention should not be limited to the specific disclosed forms.

As used herein, the singular forms, "a", "an" and "the" are intended to include the plural forms as well, unless the context clearly indicates otherwise.

It will be further understood that the terms "include" and/or "including", when used in this specification, specify the presence of stated features, integers, steps, operations, elements, and/or components, but do not preclude the presence or addition of one or more other features, integers, steps, operations, elements, components, and/or groups thereof.

In the present disclosure, it will be understood that when an element (or area, layer, or portion) is referred to as being "on", "connected to" or "coupled to" another element or layer, it can be directly on, connected or coupled to the other element or layer or intervening elements or layers may be present.

Spatially relative terms, such as "below", "lower", "above", "upper" and the like, may be used herein for ease of description to describe one element or feature's relationship to another elements or features as shown in the figures.

In the present disclosure, the term "on" may mean that a portion of an element is at a lower portion as well as an upper portion of another element.

In the present disclosure, when an element is referred to as being "directly connected" to another element, there are no intervening elements present between a layer, film region, or substrate and another layer, film, region, or substrate. For example, the term "directly connected" may mean that two layers or two members are located without employing additional adhesive therebetween.

As used herein, the term "and/or" may include any and all combinations of one or more of the associated listed items.

It will be understood that, although the terms first, second, etc. may be used herein to describe various elements, these elements should not be limited by these terms. These terms are only used to distinguish one element from another element. Thus, a first element discussed below could be termed a second element and vice versa without departing from the teachings of the present invention.

Unless otherwise defined, all terms including technical and scientific terms used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Like numerals refer to like elements throughout. In the drawings, the thickness, ratio, and dimension of components are exaggerated for effective description of the technical content.

Hereinafter, a display device and an electronic apparatus according to embodiments of the present invention will be described with reference to accompanying drawings.

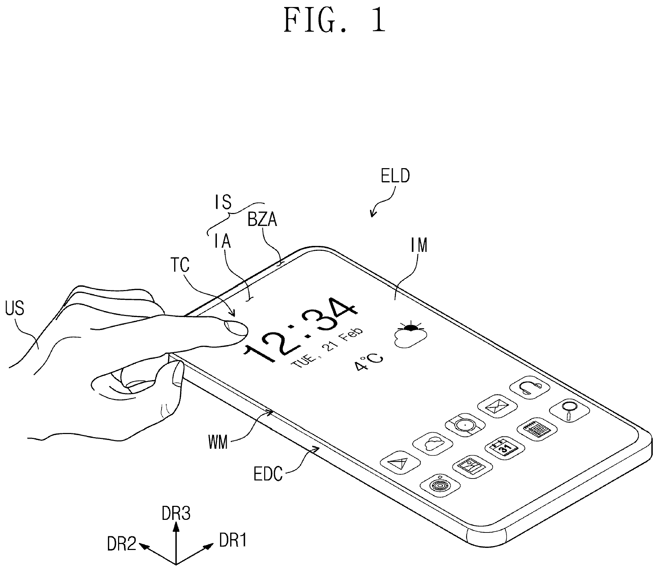

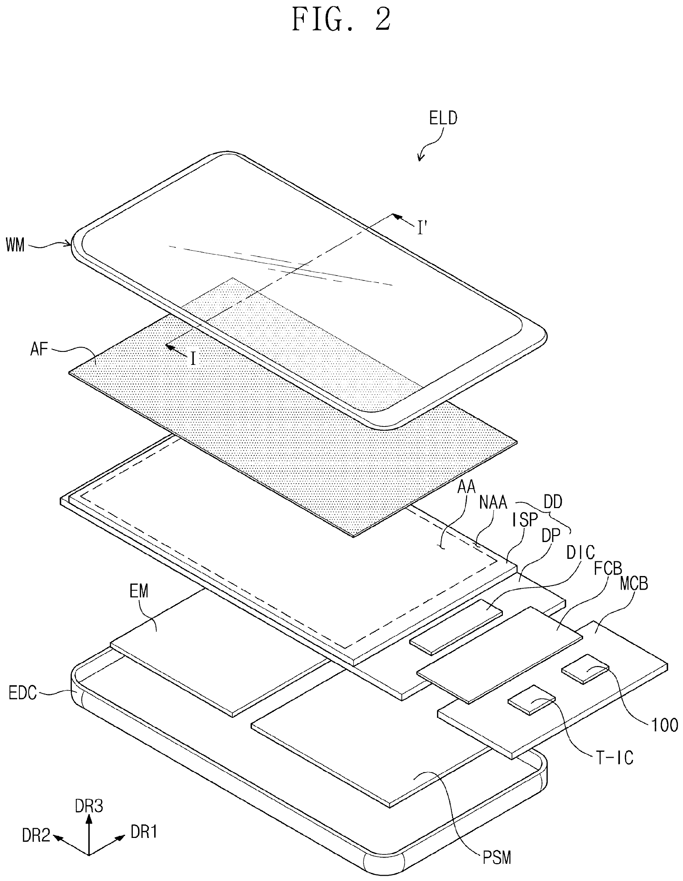

FIG. 1 is an assembled perspective view of an electronic apparatus ELD according to some embodiments of the present invention. FIG. 2 is an exploded perspective view of the electronic apparatus ELD according to some embodiments of the present invention.

Referring to FIG. 1, the electronic apparatus ELD may be activated in response to electrical signals and may display images. As an example, the electronic apparatus ELD may be applied to a large-sized display device, such as a television set, an outdoor billboard, etc., and a small and medium-sized display device, such as a monitor, a mobile phone, a tablet computer, a navigation unit, a game unit, etc. However, these are merely examples, and the electronic apparatus ELD may be applied to other display devices as long as they do not depart from the scope of embodiments according to the present invention.

The electronic apparatus ELD may be rigid or flexible. The term "flexible" used herein refers to the property of being able to be bent. For example, the electronic apparatus ELD that is flexible may be a curved device, a rollable device, or a foldable device.

In the present embodiments, a third direction DR3 may be perpendicular (or substantially perpendicular) to a plane defined by a first direction DR1 and a second direction DR2. Front (or upper) and rear (or lower) surfaces of each member of the electronic apparatus ELD may be opposite to each other in the third direction DR3, and a normal line direction of each of the front and rear surfaces may be parallel (or substantially parallel) to the third direction DR3. A separation distance between the front surface and the rear surface in the third direction DR3 may correspond to a thickness in the third direction DR3 of each member.

In the present invention, the expression "when viewed in a plane" may mean a state of being viewed in the third direction DR3. In the present invention, the expression "when viewed in a cross-section" may mean a state of being viewed in the first direction DR1 or the second direction DR2. The directions indicated by the first, second, and third directions DR1, DR2, and DR3 are relative to each other, and thus, the directions indicated by the first, second, and third directions DR1, DR2, and DR3 may be changed to other directions.

The electronic apparatus ELD may display an image IM to the third direction DR3 through a display surface IS parallel (or substantially parallel) to the plane defined by the first direction DR1 and the second direction DR2. However, the shape of the display surface IS should not be limited thereto or thereby, and the display surface IS may further include a curved surface bent from at least one side of the plane. The display surface IS through which the image IM is displayed may correspond to a front surface of the electronic apparatus ELD. The image IM may include a video as well as a still image. FIG. 1 shows a clock widget and application icons as representative examples of the image IM.

The electronic apparatus ELD may have a rectangular shape with short sides extending in the first direction DR1 and long sides extending in the second direction DR2 intersecting the first direction DR1. However, the shape of the electronic apparatus ELD should not be limited to the rectangular shape, and the electronic apparatus ELD may have a variety of shapes, such as a circular shape, a polygonal shape, etc.

The electronic apparatus ELD may sense an external input TC applied thereto from the outside. The external input TC may include inputs of various forms, such as force, pressure, temperature, light, etc. According to some embodiments, a touch input generated by a hand of a user US and applied to the front surface of the electronic apparatus ELD will be described as a representative example of the external input TC. However, this is merely example, and the external input TC may include all types of inputs that cause a variation in capacitance. The area of the electronic apparatus ELD in which the external input TC is sensed should not be limited to the front surface of the electronic apparatus ELD, and the electronic apparatus ELD may sense the external input TC by the user US applied to a side or rear surface of the electronic apparatus ELD depending on a structure of the electronic apparatus ELD.

The display surface IS of the electronic apparatus ELD may include an image area IA and a bezel area BZA. The image IM may be displayed through the image area IA. The user may view the image IM through the image area IA. According to some embodiments, the image area IA may have a quadrangular shape with rounded vertices. However, this is merely an example, and the image area IA may have a variety of shapes.

The bezel area BZA may have a color and may block the light. The bezel area BZA may be defined adjacent to the image area IA. As an example, the bezel area BZA may be located outside the image area IA and may surround the image area IA. Accordingly, the shape of the image area IA may be defined by the bezel area BZA, however, this is merely an example. That is, the bezel area BZA may be located adjacent to only one side of the image area IA, may be located at a side surface of the electronic apparatus ELD, or may be omitted.

Referring to FIGS. 1 and 2, the electronic apparatus ELD may include a window WM, a display device DD, an optical member AF, an electronic module EM, a power module PSM, and a case EDC.

The window WM may be located on the display device DD and the optical member AF. The window WM may protect the display device DD from external impacts and scratches applied to the display device DD. A front surface of the window WM may correspond to the display surface IS of the electronic apparatus ELD.

The optical member AF may be located on the display device DD. The optical member AF may decrease a reflectance of the display device DD with respect to an external light. As an example, the optical member AF may include a polarizing film including a retarder and/or a polarizer, a plurality of reflective layers destructively interfering with reflected lights, or a plurality of color filters arranged to correspond to an arrangement and a light emission color of the pixels.

The display device DD may generate the image IM that travels to the outside of the electronic apparatus ELD and may sense the external input TC. The display device DD may include a display panel DP and an input sensor ISP.

The display panel DP may display the image IM in response to electrical signals. The display panel DP according to some embodiments may be a light emitting type display panel, however, it should not be particularly limited. For instance, the display panel DP may be an organic light emitting display panel, an inorganic light emitting display panel, or a quantum dot light emitting display panel. Hereinafter, the organic light emitting display panel will be described as a representative example of the display panel DP.

The input sensor ISP may be located on the display panel DP. The input sensor ISP may sense the external input TC and may provide an input signal including information about the external input TC to allow the display panel DP to display the image IM correspond to the external input TC. The input sensor ISP may be driven in various methods, such as a capacitive method, a resistive film method, an infrared ray method, a sonic method, or a pressure method, however, it should not be particularly limited. According to some embodiments, the input sensor ISP driven in the capacitive method will be described as a representative example.

The display device DD may include an active area AA and a peripheral area NAA defined adjacent to (e.g., in a periphery or outside a footprint of) the active area AA. Light emitting elements of the display panel DP or sensing electrodes of the input sensor ISP may be located in the active area AA, and the display device DD may be activated in response to electrical signals to display the image IM in the active area AA or may sense the external input TC in the active area AA. A driving circuit, a signal line, and a pad may be located in the peripheral area NAA to drive elements in the active area AA.

The active area AA may overlap the image area IA of the electronic apparatus ELD, and the peripheral area NAA may overlap the bezel area BZA of the electronic apparatus ELD. Components located in the peripheral area NAA may be prevented from being viewed from the outside by the bezel area BZA.

The display device DD may further include a main circuit board MCB, a flexible circuit film FCB, a data driver DIC, a sensor control circuit T-IC, and a main controller 100.

The main circuit board MCB may include a plurality of driving elements. The main circuit board MCB may be electrically connected to the display panel DP and the input sensor ISP via the flexible circuit film FCB. The main circuit board MCB may be electrically connected to the electronic module EM via a connector.

The flexible circuit film FCB may be connected to the display panel DP to electrically connect the display panel DP to the main circuit board MCB. The input sensor ISP may be electrically connected to the display panel DP and may be electrically connected to the main circuit board MCB via the flexible circuit film FCB, however, the present invention should not be limited thereto or thereby. According to some embodiments, the input sensor ISP may be electrically connected to the main circuit board MCB via an additional flexible circuit film, or the flexible circuit film FCB may be omitted and the main circuit board MCB may be directly connected to the display panel DP.

Each of the data driver DIC, the sensor control circuit T-IC, and the main controller 100 may be provided in an integrated chip. The data driver DIC may be mounted on the display panel DP, and the sensor control circuit T-IC and the main controller 100 may be mounted on the main circuit board MCB, however, the present invention should not be limited thereto or thereby. According to some embodiments, the data driver DIC may be mounted on the flexible circuit film FCB.

The main controller 100 may control an overall operation of the electronic apparatus ELD. For example, the main controller 100 may control an operation of the display panel DP and the input sensor ISP. In addition, the main controller 100 may control an operation of the electronic module EM. The main controller 100 may include at least one microprocessor.

The data driver DIC may include a driving circuit to drive pixels of the display panel DP. The data driver DIC may receive image data and control signals from the main controller 100. As an example, the control signals may include an input vertical synchronization signal, an input horizontal synchronization signal, a main clock, and a data enable signals.

The sensor control circuit T-IC may provide electrical signals to the input sensor ISP to drive the input sensor ISP. The sensor control circuit T-IC may receive a control signal such as a clock signal from the main controller 100.

The electronic module EM may include a variety of functional modules to drive the display device DD. As an example, the electronic module EM may include a wireless communication module, an image input module, an audio input module, an audio output module, a memory, an external interface module, and the like. The modules of the electronic module EM may be mounted on the main circuit board MCB or may be electrically connected to the main circuit board MCB via a separate flexible circuit board.

The power module PSM may be electrically connected to the electronic module EM. The power module PSM may supply a power required for an overall operation of the electronic apparatus ELD. As an example, the power module PSM may include a conventional battery.

The case EDC may be coupled with the window WM to define an exterior of the electronic apparatus ELD. The window WM may be coupled with the case EDC to form an inner space to accommodate components of the electronic apparatus ELD. The display device DD, the flexible circuit film FCB, the main circuit board MCB, the electronic module EM, and the power module PSM may be accommodated in the inner space. The display panel DP may be bent to allow the flexible circuit film FCB and the main circuit board MCB to face a rear surface of the display device DD and then may be accommodated in the case EDC.

The case EDC may include a material with a relatively high rigidity. As an example, the case EDC may include a frame and/or a plate formed of glass, plastic, metal material, or combinations thereof. The case EDC may absorb external impacts applied thereto from the outside and may prevent or reduce instances of a contaminant, a foreign substance, or moisture entering therein to protect the display device DD.

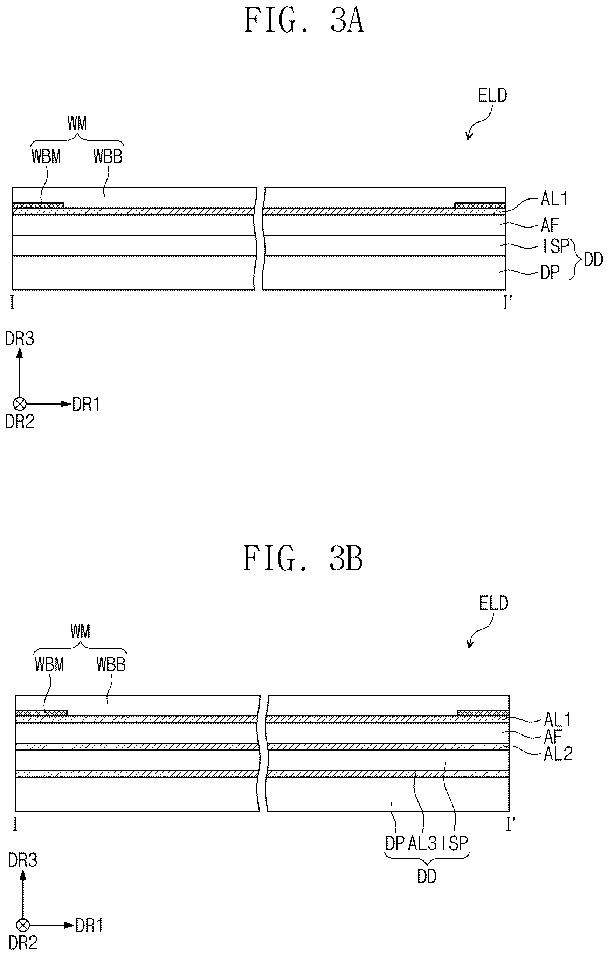

FIGS. 3A and 3B are cross-sectional views of electronic apparatuses taken along a line I-I' of FIG. 2. FIGS. 3A and 3B show various embodiments according to a stack structure of components included in the electronic apparatus EDL, and details of the window WM, the display panel DP, and the input sensor ISP described with reference to FIGS. 1 and 2 may be applied to those of FIGS. 3A and 3B.

Referring to FIGS. 3A and 3B, the window WM may include a base film WBB and a bezel pattern WBM. The base film WBB may include an optically transparent insulating material. The base film WBB may include at least one of a glass film and a synthetic resin film. The base film WBB may have a single-layer structure or a multi-layer structure of two or more films attached to each other. The window WM may further include functional layers, such as an anti-fingerprint layer, a phase control layer, a hard coating layer, etc., located on the base film WBB.

The bezel pattern WBM may be a colored layer formed on a surface of the base film WBB. The bezel pattern WBM may include a material with a color. As an example, the bezel pattern WBM may include a colored organic layer. The bezel pattern WBM may have a single-layer or multi-layer structure. The bezel pattern WBM having the multi-layer structure may include a chromatic color layer and a light blocking layer having an achromatic color, e.g., a black color. The bezel pattern WBM may be formed through a depositing, printing, or coating process.

The bezel pattern WBM may be arranged to correspond to the bezel area BZA (refer to FIG. 1) of the electronic apparatus ELD. An area of the window WM in which the bezel pattern WBM is located may have a light transmittance lower than that of an area in which the bezel pattern WBM is not located.

A first adhesive layer AL1 may be located between the window WM and the optical member AF. The window WM may be coupled with the optical member AF by the first adhesive layer AL1, however, embodiments according to the present invention are not limited thereto or thereby. According to some embodiments, the first adhesive layer AL1 may be omitted, and the window WM may be located directly on the optical member AF.

Referring to FIG. 3A, the input sensor ISP may be located directly on the display panel DP. The input sensor ISP may be formed on a base surface provided by the display panel DP through successive processes in a manufacturing process of the display device DD. The input sensor ISP may be coupled integrally with the display panel DP without a separate adhesive.

Referring to FIG. 3A, the optical member AF may be located directly on the display device DD. As an example, the optical member AF may be formed on an upper surface of the input sensor ISP through successive processes. The optical member AF may include a color filter, and the optical member AF may be formed by coating, patterning, or printing a composition for the color filter on a base surface provided by the input sensor ISP.

However, embodiments according to the present invention are not limited thereto or thereby, and referring to FIG. 3B, the optical member AF may be coupled with the display device DD by a second adhesive layer AL2. As an example, the optical member AF may be provided in the form of a film, such as a polarizing film, and may be coupled with the display device DD by the second adhesive layer AL2 located on the upper surface of the input sensor ISP.

Referring to FIG. 3B, the display device DD may further include a third adhesive layer AL3 located between the input sensor ISP and the display panel DP. The input sensor ISP may be coupled with the display panel DP by the third adhesive layer AL3. As an example, the input sensor ISP may be provided as a touch panel manufactured by a separate process different from the manufacturing process of the display panel DP, and the input sensor ISP may be coupled with the display panel DP by the third adhesive layer AL3 located on the upper surface of the display panel DP.

Each of the first, second, and third adhesive layers AL1, AL2, and AL3 may include a transparent adhesive, such as an optically clear adhesive (OCA) film, an optically clear resin (OCR), or a pressure sensitive adhesive (PSA) film, however, the adhesive included in the first, second, and third adhesive layers AL1, AL2, and AL3 should not be limited thereto or thereby.

The stack structure and the stack order of components included in the electronic apparatus ELD shown in FIGS. 3A and 3B are merely examples, and embodiments according to the present invention are not limited thereto or thereby. As an example, the electronic apparatus ELD may further include a protective layer located under the display panel DP or the optical member AF may be omitted. In addition, the stack order of the optical member AF and the input sensor ISP may be changed, and the optical member AF may be located between the display panel DP and the input sensor ISP.

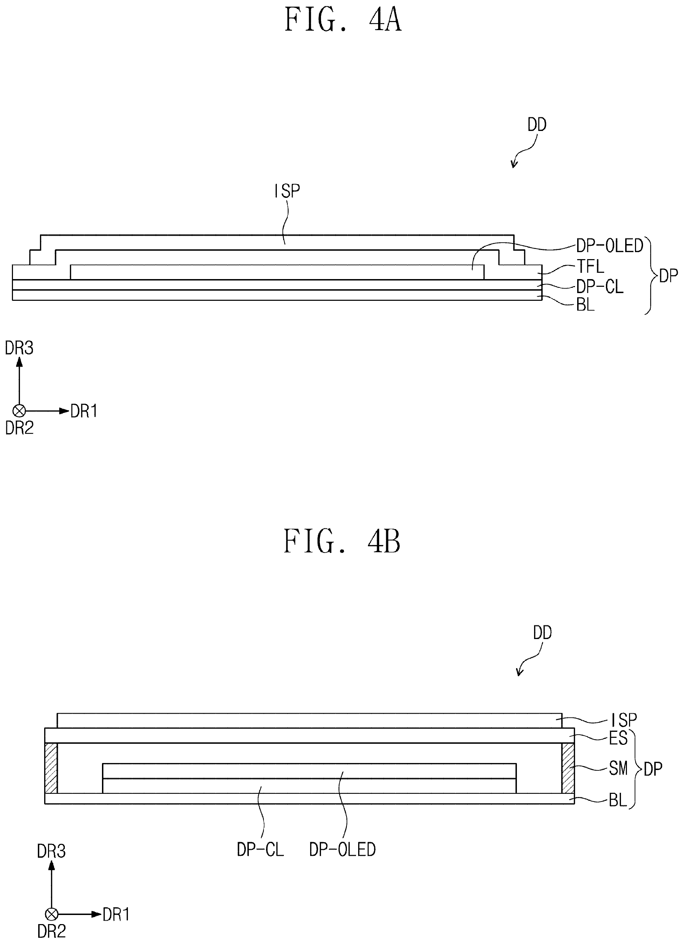

FIGS. 4A to 4C are cross-sectional views of display devices according to embodiments of the present invention. Details of the display panel DP and the input sensor ISP described above may be applied to a display panel DP and an input sensor ISP of FIGS. 4A to 4C.

Referring to FIG. 4A, the display panel DP may include a base layer BL, a circuit element layer DP-CL, a display element layer DP-OLED, and an encapsulation layer TFL.

The base layer BL may provide a base surface on which the circuit element layer DP-CL is located. The base layer BL may be a rigid substrate or a flexible substrate that is bendable, foldable, or rollable. The base layer BL may include a plastic substrate, a glass substrate, a metal substrate, or an organic/inorganic composite material substrate, however, it should not be limited thereto or thereby. The base layer BL may have a multi-layer structure. As an example, the base layer BL may include an inorganic layer, a synthetic resin layer, or a composite material layer.

The circuit element layer DP-CL may be located on the base layer BL. The circuit element layer DP-CL may include at least one insulating layer, a semiconductor pattern, and a conductive pattern. An insulating layer, a semiconductor layer, and a conductive layer may be formed by a coating or depositing process. Then, the insulating layer, the semiconductor layer, and the conductive layer may be selectively patterned through several photolithography processes, and thus, the insulating layer, the semiconductor pattern, and the conductive pattern may be formed. The insulating layer, the semiconductor pattern, and the conductive pattern included in the circuit element layer DP-CL may form driving elements, such as transistors, signal lines, and pads in the circuit element layer DP-CL.

The display element layer DP-OLED may be located on the circuit element layer DP-CL. The display element layer DP-OLED may include light emitting elements. The light emitting elements of the display element layer DP-OLED may be electrically connected to the driving elements of the circuit element layer DP-CL and may emit a light in response to a signal from the driving elements to display images.

The encapsulation layer TFL may be located on the display element layer DP-OLED and may encapsulate the light emitting elements. The encapsulation layer TFL may include at least one thin layer to relatively improve an optical efficiency of the display element layer DP-OLED or to protect the display element layer DP-OLED.

Referring to FIG. 4B, the display panel DP may include a base layer BL, a circuit element layer DP-CL, a display element layer DP-OLED, an encapsulation substrate ES, and a sealant SM.

The circuit element layer DP-CL may be located on the base layer BL, and the display element layer DP-OLED may be located on the circuit element layer DP-CL.

The sealant SM may be located between the base layer BL and the encapsulation substrate ES. The base layer BL may be combined with the encapsulation substrate ES by the sealant SM. The sealant SM may include an organic adhesive or a frit.

The encapsulation substrate ES may be located on the display element layer DP-OLED. Each of the base layer BL and the encapsulation substrate ES may include a plastic substrate, a glass substrate, a metal substrate, or an organic/inorganic composite material substrate. The encapsulation substrate ES may be spaced apart from the display element layer DP-OLED with a gap in the third direction DR3. According to some embodiments, the display panel DP may further include a filling layer filled in the gap. The filling layer may include a desiccant or resin material.

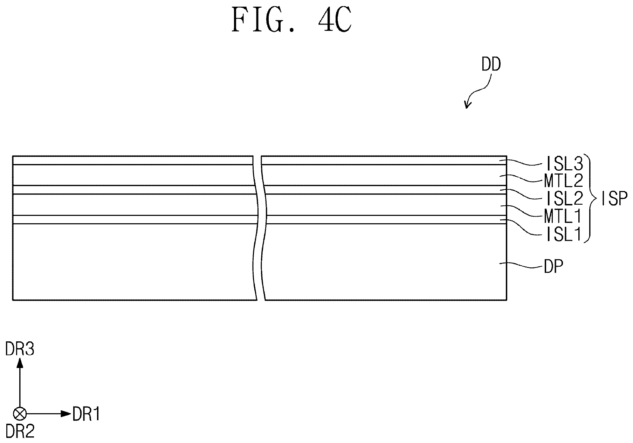

Referring to FIG. 4C, the input sensor ISP may include a sensor base layer ISL1, a first sensor conductive layer MTL1, a first sensor insulating layer ISL2, a second sensor conductive layer MTL2, and a second sensor insulating layer ISL3. The sensor base layer ISL1 may be located directly on the display panel DP, however, it should not be limited thereto or thereby. According to some embodiments, the sensor base layer ISL1 may be omitted, and in this case, the first sensor conductive layer MTL1 may be located directly on the display panel DP.

Each of the first and second sensor conductive layers MTL1 and MTL2 may have a single-layer structure or a multi-layer structure. The conductive layer having the multi-layer structure may include a transparent conductive layer and/or a metal layer, which are stacked in a two or more-layer structure. As an example, the conductive layer having the multi-layer structure may have a structure in which the transparent conductive layer and the metal layer are stacked or metal layers containing different metals are stacked.

The transparent conductive layer included in the first and second sensor conductive layers MTL1 and MTL2 may include indium tin oxide (ITO), indium zinc oxide (IZO), zinc oxide (ZnO), indium tin zinc oxide (ITZO), PEDOT, metal nanowire, or graphene. The metal layer included in the first and second sensor conductive layers MTL1 and MTL2 may include molybdenum, silver, titanium, copper, aluminum, or alloys thereof.

In the first sensor conductive layer MTL1 and the second sensor conductive layer MTL2 each having the multi-layer structure, a metal with relatively high durability and low reflectivity may be applied to an outer layer of the sensor conductive layer, and a metal with high electrical conductivity may be applied to an inner layer of the sensor conductive layer. As an example, each of the first sensor conductive layer MTL1 and the second sensor conductive layer MTL2 may have a three-layer structure of titanium/aluminum/titanium or a three-layer structure of titanium/copper/titanium. The first sensor conductive layer MTL1 and the second sensor conductive layer MTL2 may have lower resistance characteristics when they have the three-layer structure of titanium/copper/titanium than when they have the three-layer structure of titanium/aluminum/titanium.

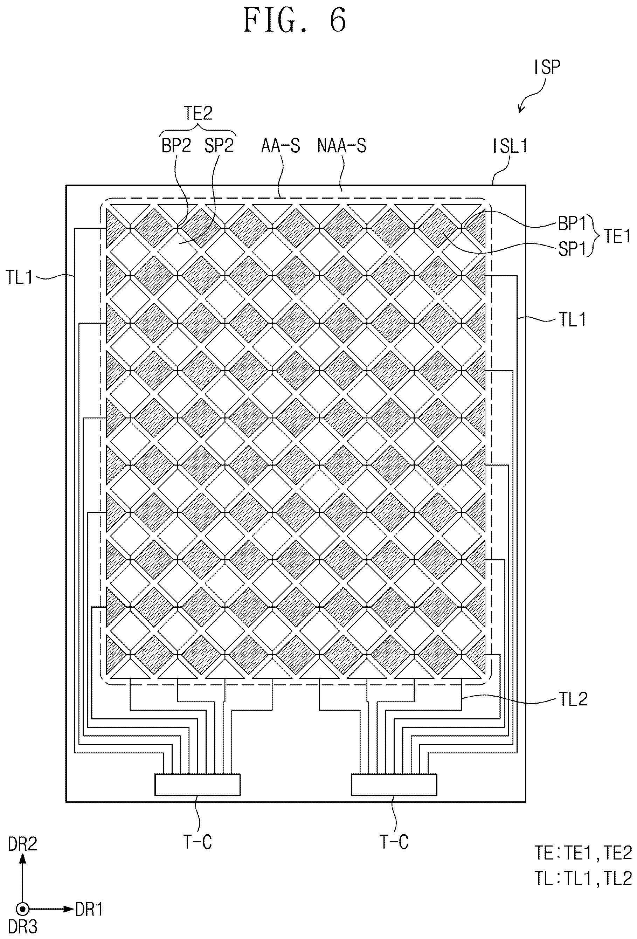

The first sensor conductive layer MTL1 and the second sensor conductive layer MTL2 may include sensing electrodes TE (refer to FIG. 6) of the input sensor ISP described later and may further include trace lines TL (refer to FIG. 6).

The first sensor insulating layer ISL2 may be located on the first sensor conductive layer MTL1. The second sensor insulating layer ISL3 may be located on the second sensor conductive layer MTL2. Each of the first sensor insulating layer ISL2 and the second sensor insulating layer ISL3 may include an inorganic layer or an organic layer.

As an example, the inorganic layer may include at least one of aluminum oxide, titanium oxide, silicon oxide, silicon oxynitride, zirconium oxide, and hafnium oxide. The organic layer may include at least one of an acrylic-based resin, a methacrylic-based resin, a polyisoprene-based resin, a vinyl-based resin, an epoxy-based resin, a urethane-based resin, a cellulose-based resin, a siloxane-based resin, a polyamide-based resin, a perylene-based resin, and a polyimide-based resin.

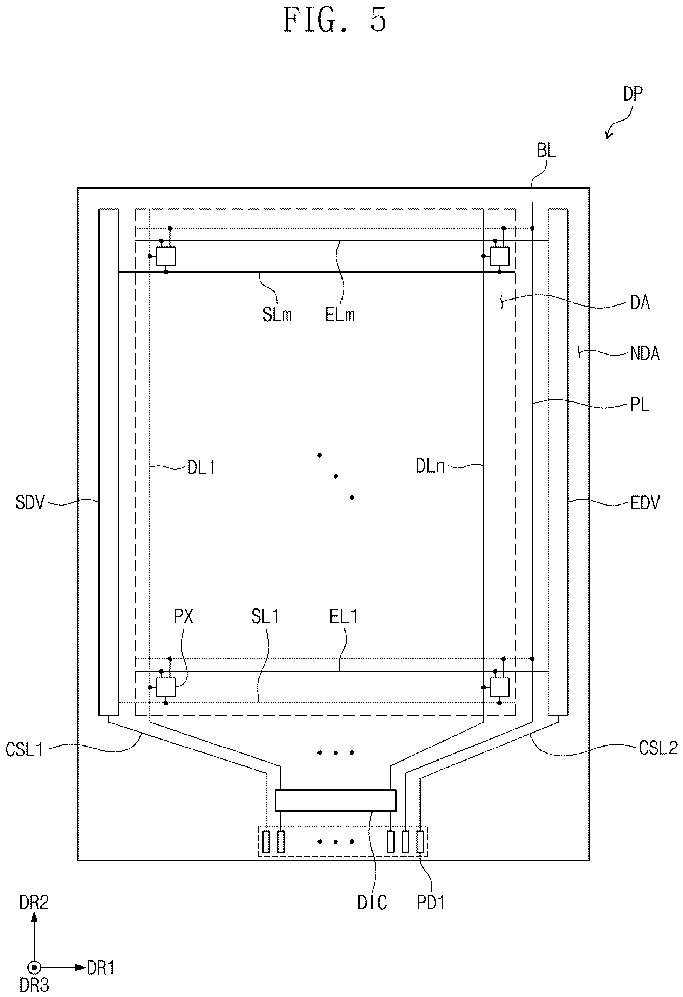

FIG. 5 is a plan view of the display panel DP according to some embodiments of the present invention.

Referring to FIG. 5, the display panel DP may include the base layer BL, a plurality of pixels PX, a plurality of signal lines SL1 to SLm, DL1 to DLn, EL1 to ELm, CSL1, CSL2, and PL electrically connected to the pixels PX, a scan driver SDV, the data driver DIC, an emission driver EDV, and a plurality of pads PD1.

The base layer BL may provide a base surface on which elements and lines of the display panel DP are located. The base layer BL may include a display area DA and a non-display area NDA. The display area DA may be an area in which the pixels PX are arranged to display images, and the non-display area NDA may be an area in which elements and lines are located to drive the pixels PX and the images are not displayed and may be located adjacent to the display area DA. The display area DA may correspond to the active area AA (refer to FIG. 2) of the display device DD, and the non-display area NDA may correspond to the peripheral area NAA (refer to FIG. 2) of the display device DD.

Each of the pixels PX may include a pixel driving circuit including a plurality of transistors, e.g., a switching transistor, a driving transistor, etc., and a capacitor and a light emitting element electrically connected to the pixel driving circuit. Each of the pixels PX may emit a light in response to electrical signals applied thereto.

Each of the scan driver SDV, the data driver DIC, and the emission driver EDV may be located in the non-display area NDA, however, the present invention should not be limited thereto or thereby. According to some embodiments, at least one of the scan driver SDV, the data driver DIC, and the emission driver EDV may be located in the display area DA, and thus, a size of the non-display area NDA may be relatively reduced.

The signal lines SL1 to SLm, DL1 to DLn, EL1 to ELm, CSL1, CSL2, and PL may include a plurality of scan lines SL1 to SLm, a plurality of data lines DL1 to DLn, a plurality of emission lines EL1 to ELm, a first control line CSL1, a second control line CSL2, and a power line PL. Each of m and n is a natural number. Each of the pixels PX may be electrically connected to a corresponding scan line among the scan lines SL1 to SLm, a corresponding data line among the data lines DL1 to DLn, and a corresponding emission line among the emission lines EL1 to ELm. More types of signal lines may be provided in the display panel DP depending on the configuration of the pixel driving circuit of the pixels PX.

The scan lines SL1 to SLm may extend in a direction parallel to the first direction DR1 and may be electrically connected to the scan driver SDV. The data lines DL1 to DLn may extend in a direction parallel to the second direction DR2 and may be electrically connected to the data driver DIC. The emission lines EL1 to ELm may extend in the first direction DR1 and may be electrically connected to the emission driver EDV.

The power line PL may include a portion extending in the first direction DR1 and a portion extending in the second direction DR2. The portion of the power line PL extending in the first direction DR1 and the portion of the power line PL extending in the second direction DR2 may be located on different layers from each other and may be connected to each other via a contact hole, however, they should not be limited thereto or thereby. According to some embodiments, the portion of the power line PL extending in the first direction DR1 and the portion of the power line PL extending in the second direction DR2 may be located at the same layer and may be provided integrally with each other.

The portion of the power line PL extending in the first direction DR1 may extend to the display area DA and may be electrically connected to the pixels PX, and the portion of the power line PL extending in the second direction DR2 may be located in the non-display area NDA and may extend to the pads PD1. The power line PL may receive a power supply voltage and may provide the power supply voltage to the pixels PX.

The first control line CSL1 may be electrically connected to the scan driver SDV. The second control line CSL2 may be electrically connected to the emission driver EDV.

The pads PD1 may be located adjacent to a lower end of the non-display area NDA. The pads PD1 may be located closer to a lower end of the display panel DP than the data driver DIC is. The pads PD1 may be arranged spaced apart from each other in the first direction DR1. The pads PD1 may be electrically connected to a circuit board that provides a signal to control an operation of the scan driver SDV, the data driver DIC, and the emission driver EDV.

Each of the pads PD1 may be connected to a corresponding signal line among the signal lines SL1 to SLm, DL1 to DLn, EL1 to ELm, CSL1, CSL2, and PL. As an example, the power line PL, the first and second control lines CSL1 and CSL2, and the data lines DL1 to DLn may be connected to corresponding pads PD1. The data lines DL1 to DLn may be connected to the corresponding pads PD1 via the data driver DIC.

The scan driver SDV may generate a plurality of scan signals in response to a scan control signal. The scan signals may be applied to the pixels PX via the scan lines SL1 to SLm. The data driver DIC may generate a plurality of data voltages corresponding to image signals in response to a data control signal. The data voltages may be applied to the pixels PX via the data lines DL1 to DLn. The emission driver EDV may generate a plurality of emission signals in response to an emission control signal. The emission signals may be applied to the pixels PX via the emission lines EL1 to ELm.

The pixels PX may receive the data voltages in response to the scan signals. The pixels PX may emit a light having a luminance corresponding to the data voltages in response to the emission signals, and thus, the image may be displayed. An emission time of the pixels PX may be controlled by the emission signals. Accordingly, the display panel DP may display the image through the display area DA using the pixels PX.

FIG. 6 is a plan view of the input sensor ISP according to some embodiments of the present invention.

Referring to FIG. 6, the input sensor ISP may include a sensing area AA-S and a non-sensing area NAA-S defined adjacent to the sensing area AA-S. The sensing area AA-S may correspond to the active area AA (refer to FIG. 2) of the display device DD (refer to FIG. 2). The sensing electrodes TE of the input sensor ISP may be located in the sensing area AA-S and may sense the external input TC (refer to FIG. 1). The non-sensing area NAA-S may correspond to the peripheral area NAA (refer to FIG. 2) of the display device DD (refer to FIG. 2). Elements and lines may be located in the non-sensing area NAA-S to drive the sensing electrodes TE located in the sensing area AA-S.

The input sensor ISP may include the sensing electrodes TE, the trace lines TL, and a sensing controller T-C, which are located on the sensor base layer ISL1.

The sensing electrodes TE may include first sensing electrodes TE1 and second sensing electrodes TE2 electrically insulated from the first sensing electrodes TE1 while intersecting the first sensing electrodes TE1 when viewed in the plane. The input sensor ISP may obtain information about the external input based on a variation in mutual capacitance between the first sensing electrodes TE1 and the second sensing electrodes TE2.

Each of the first sensing electrodes TE1 may extend in the first direction DR1, and the first sensing electrodes TE1 may be arranged in the second direction DR2. The first sensing electrodes TE1 may be arranged in a plurality of rows arranged in the second direction DR2. FIG. 6 shows ten first sensing electrodes TE1 as a representative example, however, the number of the first sensing electrodes TE1 included in the input sensor ISP should not be limited thereto or thereby.

Each of the second sensing electrodes TE2 may extend in the second direction DR2, and the second sensing electrodes TE2 may be arranged in the first direction DR1. The second sensing electrodes TE2 may be arranged in a plurality of columns arranged in the first direction DR1. FIG. 6 shows eight second sensing electrodes TE2 as a representative example, however, the number of the second sensing electrodes TE2 included in the input sensor ISP should not be limited thereto or thereby.

Each of the first sensing electrodes TE1 may include first sensing patterns SP1 and first connection patterns BP1. The first sensing patterns SP1 may be arranged in the first direction DR1. The first connection patterns BP1 may connect the first sensing patterns SP1 adjacent to each other in the first direction DR1. The first connection patterns BP1 may be located at the same layer as the first sensing patterns SP1, may extend from the first sensing patterns SP1 when viewed in the plane, and may be provided integrally with the first sensing patterns SP1. The first sensing patterns SP1 and the first connection patterns BP1 may be formed of the same conductive layer by patterning the conductive layer through the same process. However, the first connection patterns BP1 should not be particularly limited as long as the first connection patterns BP1 electrically connect the first sensing patterns SP1 adjacent to each other in the first direction DR1.

Each of the second sensing electrodes TE2 may include second sensing patterns SP2 and second connection patterns BP2. The second sensing patterns SP2 may be arranged in the second direction DR2. The second connection patterns BP2 may connect the second sensing patterns SP2 adjacent to each other in the second direction DR2. The second connection patterns BP2 may be located on a different layer from the second sensing patterns SP2 and may be connected to corresponding second sensing patterns SP2 through contact holes. The second sensing patterns SP2 spaced apart from each other in the second direction DR2 may be electrically connected to each other through the second connection patterns BP2. The second connection patterns BP2 located on a different layer from the second sensing patterns SP2 and electrically connecting the second sensing patterns SP2 may be defined as bridge patterns.

According to some embodiments, the first sensing patterns SP1, the first connection patterns BP1, and the second sensing patterns SP2 may be located at the same layer. The second connection patterns BP2 and the second sensing patterns SP2 may be located on different layers from each other. As an example, the first sensing patterns SP1, the first connection patterns BP1, and the second sensing patterns SP2 may be included in the second sensor conductive layer MTL2 (refer to FIG. 4C), and the second connection patterns BP2 may be included in the first sensor conductive layer MTL1 (refer to FIG. 4C), however, the present invention should not be limited thereto or thereby. According to some embodiments, the first sensing patterns SP1, the first connection patterns BP1, and the second sensing patterns SP2 may be included in the first sensor conductive layer MTL1 (refer to FIG. 4C), and the second connection patterns BP2 may be included in the second sensor conductive layer MTL2 (refer to FIG. 4C). According to some embodiments, the first sensing patterns SP1, the second sensing patterns SP2, and the second connection patterns BP2 may be located at the same layer, and the first connection patterns BP1 and the first sensing patterns SP1 may be located on different layers from each other.

The trace lines TL may include first trace lines TL1 and the second trace lines TL2. Each of the first trace lines TL1 may be connected to the first sensing electrodes TE1. Each of the first trace lines TL1 may be connected to the first sensing electrodes TE1 arranged in a corresponding row among the first sensing electrodes TE1 arranged in the plural rows. Each of the second trace lines TL2 may be connected to the second sensing electrodes TE2. Each of the second trace lines TL2 may be connected to the second sensing electrodes TE2 arranged in a corresponding column among the second sensing electrodes TE2 arranged in the plural columns.

The second trace lines TL2 may be respectively connected to lower ends of the second sensing electrodes TE2 adjacent to the sensing controller T-C. Each of the second trace lines TL2 may extend from the lower end of the corresponding second sensing electrode TE2 in the non-sensing area NAA-S and may be connected to the sensing controller T-C.

The first trace lines TL1 may be connected to left or right ends of the first sensing electrodes TE1. As an example, among the first trace lines TL1, each of the first trace lines TL1 connected to the first sensing electrodes TE1 arranged in an odd-numbered row may be connected to the left end of the corresponding first sensing electrode TE1 among the first sensing electrodes TE1 arranged in the odd-numbered row. Among the first trace lines TL1, each of the first trace lines TL1 connected to the first sensing electrodes TE1 arranged in an even-numbered row may be connected to the right end of the corresponding first sensing electrode TE1 among the first sensing electrodes TE1 arranged in the even-numbered row. Each of the first trace lines TL1 may extend from the left or right end of the corresponding first sensing electrode TE1 to a direction parallel to the first direction DR1 and a direction parallel to the second direction DR2 in the non-sensing area NAA-S and may be connected to the sensing controller T-C.

The first trace lines TL1 may be located on a different layer from at least a portion of the second sensing electrodes TE2. As an example, the first trace lines TL1 may be located on a different layer from the second sensing patterns SP2. According to some embodiments, the first trace lines TL1 may be included in the first sensor conductive layer MTL1 (refer to FIG. 4C), and the second sensing patterns SP2 may be included in the second sensor conductive layer MTL2 (refer to FIG. 4C), however, the present invention should not be limited thereto or thereby.

The sensing controller T-C may be located in the non-sensing area NAA-S. The sensing controller T-C may be located closer to a lower end of the sensor base layer ISL1. The sensing controller T-C may be electrically connected to the trace lines TL. The sensing controller T-C may apply a signal to the sensing electrodes TE through the trace lines TL or may receive a signal from the sensing electrodes TE through the trace lines TL. The sensing controller T-C may include a controller and may generate coordinate values for a location to which the external input is provided based on the signal received from the sensing electrodes TE. However, the present invention should not be limited thereto or thereby. According to some embodiments, the sensing controller T-C may include sensing pads spaced apart from each other and respectively connected to the trace lines TL, and the sensing pads may be electrically connected to a circuit board providing a driving signal.

Driving signals to drive the first sensing electrodes TE1 and the second sensing electrodes TE2 may be applied to the first sensing electrodes TE1 and the second sensing electrodes TE2 from the sensing controller T-C through the second trace lines TL2. Signals including information sensed by the first sensing electrodes TE1 and the second sensing electrodes TE2 may be output through the first trace lines TL1, however, the present invention should not be limited thereto or thereby.

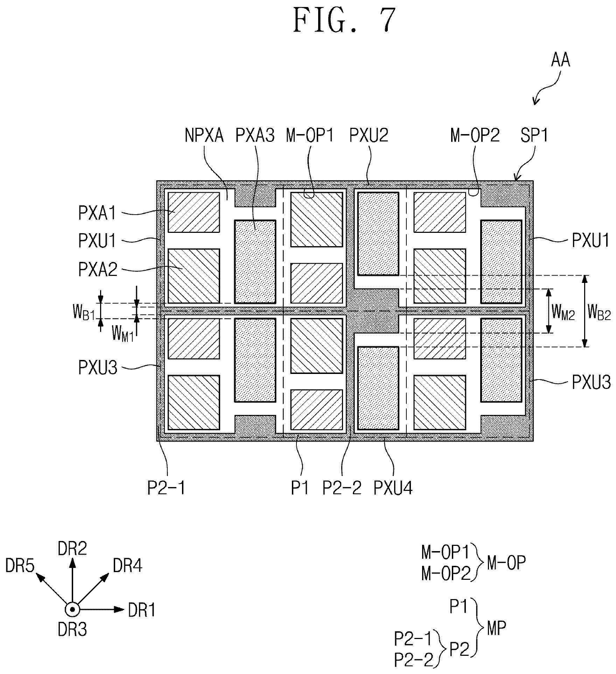

FIGS. 7, 8A, 8B, 9A, and 9B are enlarged plan views of active areas according to embodiments of the present invention.

FIGS. 7 to 9B show a portion of the first sensing pattern SP1, and detailed descriptions of the first sensing pattern SP1 may be applied to the second sensing pattern SP2 (refer to FIG. 6). Hereinafter, the first sensing pattern SP1 will be referred to as the sensing pattern SP1.

The display panel DP (refer to FIG. 2) may include light emitting areas PXA1, PXA2, and PXA3 and a non-light-emitting area NPXA surrounding the light emitting areas PXA1, PXA2, and PXA3. For the convenience of explanation, FIGS. 7 to 9B show the light emitting areas PXA1, PXA2, and PXA3 of the display panel DP (refer to FIG. 2), the non-light-emitting area NPXA of the display panel DP (refer to FIG. 2), and the sensing pattern SP1 of the input sensor ISP (refer to FIG. 2).

The light emitting areas PXA1, PXA2, and PXA3 may include a first light emitting area PXA1, a second light emitting area PXA2, and a third light emitting area PXA3. The first, second, and third light emitting areas PXA1, PXA2, and PXA3 may be distinguished from each other according to colors of lights emitted therefrom. The first light emitting area PXA1 may emit a first color light, the second light emitting area PXA2 may emit a second color light, the third light emitting area PXA3 may emit a third color light, and the first, second, and third color lights may be different from each other. As an example, the first color light may be a red light, the second color light may be a green light, and the third color light may be a blue light, however, the present invention should not be limited thereto or thereby.

The non-light-emitting area NPXA may surround the first, second, and third light emitting areas PXA1, PXA2, and PXA3. The non-light-emitting area NPXA may define a boundary between the first, second, and third light emitting areas PXA1, PXA2, and PXA3. Accordingly, the non-light-emitting area NPXA may prevent or reduce a color mixture between the first, second, and third light emitting areas PXA1, PXA2, and PXA3.

Sizes of the first, second, and third light emitting areas PXA1, PXA2, and PXA3 may be designed in various ways depending on the colors of the emitted lights and a resolution of the display panel DP (refer to FIG. 2). The first, second, and third light emitting areas PXA1, PXA2, and PXA3 may have different sizes from each other. As an example, the third light emitting area PXA3 may have the largest size among the first, second, and third light emitting areas PXA1, PXA2, and PXA3.

Each of the first, second, and third light emitting areas PXA1, PXA2, and PXA3 may have a variety of shapes, such as a polygonal shape, a circular shape, or an oval shape, when viewed in the plane. In the present disclosure, the term "polygonal shape" as used herein may include a polygonal shape in a mathematical sense and a polygonal shape whose vertices are curved. The shape of the first, second, and third light emitting areas PXA1, PXA2, and PXA3 may correspond to a shape of a light emitting opening defined through a pixel definition layer.

The first sensing electrodes TE1 (refer to FIG. 6) and the second sensing electrodes TE2 (refer to FIG. 6) may include a mesh pattern MP through which mesh openings M-OP are defined. The mesh openings M-OP may overlap the first, second, and third light emitting areas PXA1, PXA2, and PXA3. The mesh pattern MP may not overlap the first, second, and third light emitting areas PXA1, PXA2, and PXA3 and may overlap the non-light-emitting area NPXA.

Each of the first light emitting area PXA1, the second light emitting area PXA2, and the third light emitting area PXA3 may be provided in plural, and the first light emitting areas PXA1, the second light emitting areas PXA2, and the third light emitting areas PXA3 may be arranged in an arrangement when viewed in the plane. The arrangement and size of the mesh openings M-OP may be changed in various ways depending on the arrangement and size of the first, second, and third light emitting areas PXA1, PXA2, and PXA3, and thus, the shape of the mesh pattern MP may vary corresponding to the arrangement and size of the first, second, and third light emitting areas PXA1, PXA2, and PXA3. The first, second, and third light emitting areas PXA1, PXA2, and PXA3 may be spaced apart from each other with the same or different distances.

Referring to FIG. 7, each of the first, second, and third light emitting areas PXA1, PXA2, and PXA3 may be provided in plural.

The first light emitting areas PXA1 may be alternately arranged with the second light emitting areas PXA2 in the direction parallel to the second direction DR2 to form a first column. The third light emitting areas PXA3 may be arranged in the direction parallel to the second direction DR2 to form a second column. The first column may be alternately arranged with the second column in the first direction DR1. In first columns, the arrangement order of the first light emitting areas PXA1 and the second light emitting areas PXA2 may be different for each column.

In the present invention, a fourth direction DR4 may intersect each of the first direction DR1 and the second direction DR2 when viewed in the plane defined by the first direction DR1 and the second direction DR2. A fifth direction DR5 may intersect each of the first direction DR1, the second direction DR2, and the fourth direction DR4 when viewed in the plane defined by the first direction DR1 and the second direction DR2.

The first light emitting areas PXA1 may be arranged in the fifth direction DR5 with the third light emitting area PXA3 interposed therebetween. The second light emitting areas PXA2 may be arranged in the fourth direction DR4 with the third light emitting area PXA3 interposed therebetween.

One first light emitting area PXA1, one second light emitting area PXA2, and one third light emitting area PXA3, which are adjacent to each other, may form one unit pixel PXU1, PXU2, PXU3, or PXU4.

A second unit pixel PXU2 may be alternately arranged with a first unit pixel PXU1 in the first direction DR1. A third unit pixel PXU3 may be alternately arranged with the first unit pixel PXU1 in the second direction DR2. A fourth unit pixel PXU4 may be alternately arranged with the second unit pixel PXU2 in the second direction DR2. The fourth unit pixel PXU4 may be alternately arranged with the third unit pixel PXU3 in the first direction DR1.

In the first unit pixel PXU1, the first light emitting area PXA1 may be spaced apart from the second light emitting area PXA2 in the second direction DR2, and the third light emitting area PXA3 may be spaced apart from each of the first and second light emitting areas PXA1 and PXA2 in the first direction DR1.

In the second unit pixel PXU2, the second light emitting area PXA2 may be spaced apart from the first light emitting area PXA1 in the second direction DR2, and the third light emitting area PXA3 may be spaced apart from each of the first and second light emitting areas PXA1 and PXA2 in the first direction DR1.

That is, the first light emitting area PXA1 of the first unit pixel PXU1 may be alternately arranged with the second light emitting area PXA2 of the second unit pixel PXU2 in the first direction DR1 to form a first row, and the second light emitting area PXA2 of the first unit pixel PXU1 may be alternately arranged with the first light emitting area PXA1 of the second unit pixel PXU2 in the first direction DR1 to form a second row.

In the third unit pixel PXU3, the first light emitting area PXA1 may be spaced apart from the second light emitting area PXA2 in the second direction DR2, and the third light emitting area PXA3 may be spaced apart from each of the first and second light emitting areas PXA1 and PXA2 in the first direction DR1.

In the fourth unit pixel PXU4, the second light emitting area PXA2 may be spaced apart from the first light emitting area PXA1 in the second direction DR2, and the third light emitting area PXA3 may be spaced apart from each of the first and second light emitting areas PXA1 and PXA2 in the first direction DR1.

That is, the first light emitting area PXA1 of the third unit pixel PXU3 may be alternately arranged with the second light emitting area PXA2 of the fourth unit pixel PXU4 in the first direction DR1 to form a third row, and the second light emitting area PXA2 of the third unit pixel PXU3 may be alternately arranged with the first light emitting area PXA1 of the fourth unit pixel PXU4 in the first direction DR1 to form a fourth row.

The arrangement relationship between the first light emitting area PXA1 and the second light emitting area PXA2 in the first row formed by the first light emitting area PXA1 of the first unit pixel PXU1 and the second light emitting area PXA2 of the second unit pixel PXU2, which are alternately arranged in the first direction DR1, is the same as the arrangement relationship between the first light emitting area PXA1 and the second light emitting area PXA2 in the third row formed by the first light emitting area PXA1 of the third unit pixel PXU3 and the second light emitting area PXA2 of the fourth unit pixel PXU4, which are alternately arranged in the first direction DR1.

The arrangement relationship between the first light emitting area PXA1 and the second light emitting area PXA2 in the second row formed by the second light emitting area PXA2 of the first unit pixel PXU1 and the first light emitting area PXA1 of the second unit pixel PXU2, which are alternately arranged in the first direction DR1, is the same as the arrangement relationship between the first light emitting area PXA1 and the second light emitting area PXA2 in the fourth row formed by the second light emitting area PXA2 of the third unit pixel PXU3 and the first light emitting area PXA1 of the fourth unit pixel PXU4, which are alternately arranged in the first direction DR1.

Distances in the second direction DR2 between the third light emitting areas PXA3 may be different from each other. A first distance W_{B1} between the third light emitting area PXA3 of the first unit pixel PXU1 and the third light emitting area PXA3 of the third unit pixel PXU3 may be different from a second distance W_{B2} between the third light emitting area PXA3 of the second unit pixel PXU2 and the third light emitting area PXA3 of the fourth unit pixel PXU4. The second distance W_{B2} between the third light emitting area PXA3 of the second unit pixel PXU2 and the third light emitting area PXA3 of the fourth unit pixel PXU4 may be greater than the first distance W_{B1} between the third light emitting area PXA3 of the first unit pixel PXU1 and the third light emitting area PXA3 of the third unit pixel PXU3. In the present invention, the first distance W_{B1} and the second distance W_{B2} may mean the distance in the second direction DR2.

The mesh pattern MP may include a first line portion P1 and a second line portion P2. The first and second line portions P1 and P2 may be provided integrally with each other. The first and second line portions P1 and P2 may be connected to each other to define the mesh openings M-OP overlapping the first, second, and third light emitting areas PXA1, PXA2, and PXA3. The first and second line portions P1 and P2 may be formed by patterning a conductive layer to define the mesh openings M-OP through the conductive layer. The first and second line portions P1 and P2 may be located in the non-light-emitting area NPXA and may surround the first, second, and third light emitting areas PXA1, PXA2, and PXA3.

The first line portion P1 and the second line portion P2 may have the same or different widths from each other, and they should not be particularly limited. In addition, the width of each of the first line portion P1 and the second line portion P2 may or may not be constant.

The first line portion P1 may correspond to a portion of the mesh pattern MP, which extends in the first direction DR1. The first line portion P1 may not cross over the unit pixels PXU1, PXU2, PXU3, and PXU4 and may be located at an edge of the unit pixels PXU1, PXU2, PXU3, and PXU4.

The first line portion P1 may be located between the unit pixels adjacent to each other in the second direction DR2. The first line portion P1 may be located between the first unit pixel PXU1 and the third unit pixel PXU3 and between the second unit pixel PXU2 and the fourth unit pixel PXU4.

In detail, the first line portion P1 may be located between the second light emitting area PXA2 of the first unit pixel PXU1 and the first light emitting area PXA1 of the third unit pixel PXU3, between the third light emitting area PXA3 of the first unit pixel PXU1 and the third light emitting area PXA3 of the third unit pixel PXU3, between the first light emitting area PXA1 of the second unit pixel PXU2 and the second light emitting area PXA2 of the fourth unit pixel PXU4, and between the third light emitting area PXA3 of the second unit pixel PXU2 and the third light emitting area PXA3 of the fourth unit pixel PXU4.

A first width W_{M1} of the first line portion P1 located between the third light emitting area PXA3 of the first unit pixel PXU1 and the third light emitting area PXA3 of the third unit pixel PXU3 may be different from a second width W_{M2} of the first line portion P1 located between the third light emitting area PXA3 of the second unit pixel PXU2 and the third light emitting area PXA3 of the fourth unit pixel PXU4. The second width W_{M2} of the first line portion P1 located between the third light emitting area PXA3 of the second unit pixel PXU2 and the third light emitting area PXA3 of the fourth unit pixel PXU4 may be greater than the first width W_{M1} of the first line portion P1 located between the third light emitting area PXA3 of the first unit pixel PXU1 and the third light emitting area PXA3 of the third unit pixel PXU3. In the present embodiments, the first width W_{M1} and the second width W_{M2} may mean a length in a direction perpendicular to a direction in which the first line portion P1 extends. As an example, when the first line portion P1 extends in the first direction DR1 as shown in FIG. 7, the first width W_{M1} and the second width W_{M2} may mean a length in the second direction DR2. Different from the structure of FIG. 7, when the first line portion P1 extends at an angle with respect to the first direction DR1 between the third light emitting area PXA3 of the first unit pixel PXU1 and the third light emitting area PXA3 of the third unit pixel PXU3 or between the third light emitting area PXA3 of the second unit pixel PXU2 and the third light emitting area PXA3 of the fourth unit pixel PXU4, the first width W_{M1} and the second width W_{M2} may mean a length in a direction forming the angle with the second direction DR2.

The second line portion P2 may correspond to a portion of the mesh pattern MP, which extends in the second direction DR2. The second line portion P2 may include a second-first line portion P2-1 and a second-second line portion P2-2 alternately arranged with the second-first line portion P2-1 in the first direction DR1. The second-first line portion P2-1, the second-second line portion P2-2, and the first line portion P1 may be provided integrally with each other.

The second-first line portion P2-1 may not cross over the unit pixels PXU1, PXU2, PXU3, and PXU4 and may be located at an edge of the unit pixels PXU1, PXU2, PXU3, and PXU4. The second-second line portion P2-2 may cross over at least one of four unit pixels PXU1, PXU2, PXU3, and PXU4. As an example, the second-second line portion P2-2 may cross over the second unit pixel PXU2 and the fourth unit pixel PXU4. Only six unit pixels are shown in FIGS. 7 to 9B, and when seven or more unit pixels are shown, the second-second line portion P2-2 may cross over the first unit pixel PXU1 and the third unit pixel PXU3.

One mesh opening M-OP may be defined by two first line portions P1 and two second line portions P2. In detail, one mesh opening M-OP may be defined by two first line portions P1, one second-first line portion P2-1, and one second-second line portion P2-2.

One mesh opening M-OP may include four or five light emitting areas PXA1, PXA2, and PXA3. As an example, a first mesh opening M-OP1 may include five light emitting areas PXA1, PXA2, and PXA3. In detail, the first mesh opening M-OP1 may include two first light emitting areas PXA1, two second light emitting areas PXA2, and one third light emitting area PXA3. In addition, a second mesh opening M-OP2 may include four light emitting areas PXA1, PXA2, and PXA3. In detail, the second mesh opening M-OP2 may include one first light emitting area PXA1, one second light emitting area PXA2, and two third light emitting areas PXA3.

One mesh opening M-OP may include a portion overlapping two light emitting areas PXA1 PXA2, and PXA3 in the first direction DR1. One mesh opening M-OP may include a portion overlapping three light emitting areas PXA1, PXA2, and PXA3 in the second direction DR2.

The display device according to the present invention may have a high resolution by decreasing a density of the mesh pattern of the sensor conductive layer. In addition, a resistance of the mesh pattern may be adjusted by increasing or decreasing the width of the mesh pattern to prevent or reduce the resistance reduction due to the decrease in density of the mesh pattern. In addition, according to the display device of the present invention, the first to third light emitting areas may be arranged within the mesh opening to relatively reduce a difference in degree of light blocking according to the viewing angle (luminance versus angle). Accordingly, the density of the mesh pattern may be relatively reduced without deteriorating optical characteristics such as a viewing angle color shift, a white angular dependency, or the like.

That is, the display device according to the present invention includes the display panel having the pixel arrangement capable of relatively reducing the difference in degree of light blocking according to the viewing angle between lights of different colors and the input sensor having the arrangement of metal wiring. Thus, the high-resolution display device with excellent display characteristics and sensing characteristics may be provided.

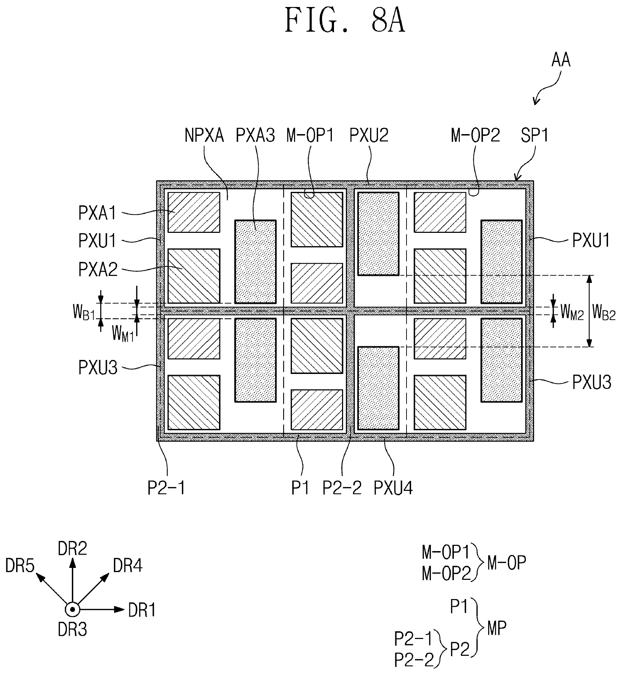

FIGS. 8A to 9B are enlarged plan views of active areas according to embodiments of the present invention. Descriptions that are the same as those explained in FIG. 7 are omitted in FIGS. 8A to 9B.

Referring to FIG. 8A, a first line portion P1 may have the same width as that of a second line portion P2. The width of the first line portion P1 may be uniform.

The width of the second line portion P2 may be uniform. As an example, a first width W_{M1} of the first line portion P1 located between a third light emitting area PXA3 of a first unit pixel PXU1 and a third light emitting area PXA3 of a third unit pixel PXU3 may be the same as a second width W_{M2} of the first line portion P1 located between a third light emitting area PXA3 of the second unit pixel PXU2 and a third light emitting area PXA3 of the fourth unit pixel PXU4, however, the present invention should not be limited thereto or thereby.

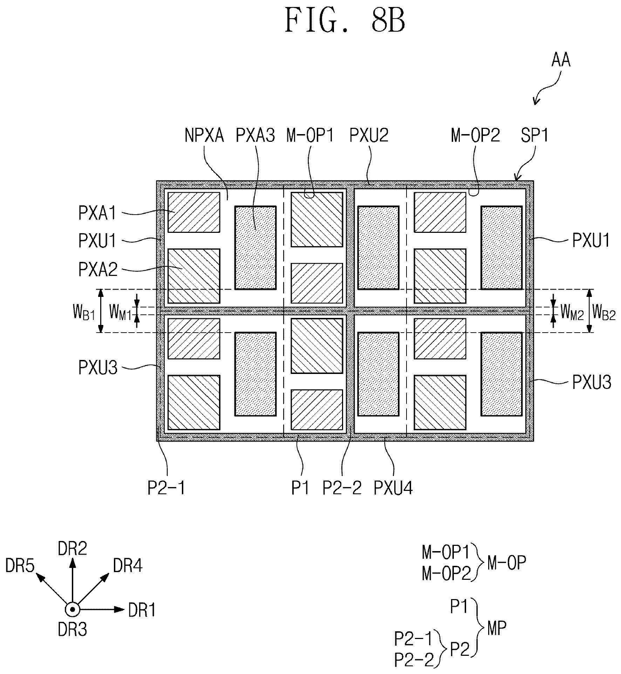

Referring to FIG. 8B, distances in the second direction DR2 between third light emitting areas PXA3 may be uniform. As an example, a first distance W_{B1} between a third light emitting area PXA3 of a first unit pixel PXU1 and a third light emitting area PXA3 of a third unit pixel PXU3 may be the same (or substantially the same) as a second distance W_{B2} between a third light emitting area PXA3 of a second unit pixel PXU2 and a third light emitting area PXA3 of a fourth unit pixel PXU4, however, the present invention should not be limited thereto or thereby.

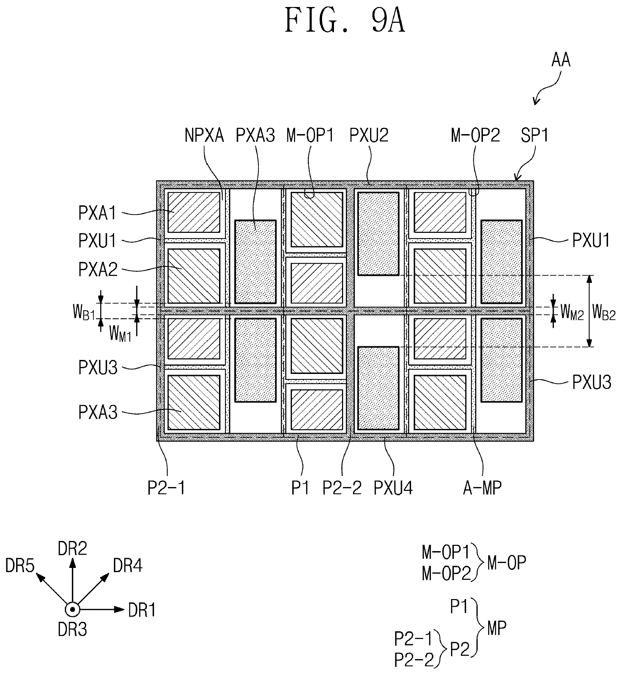

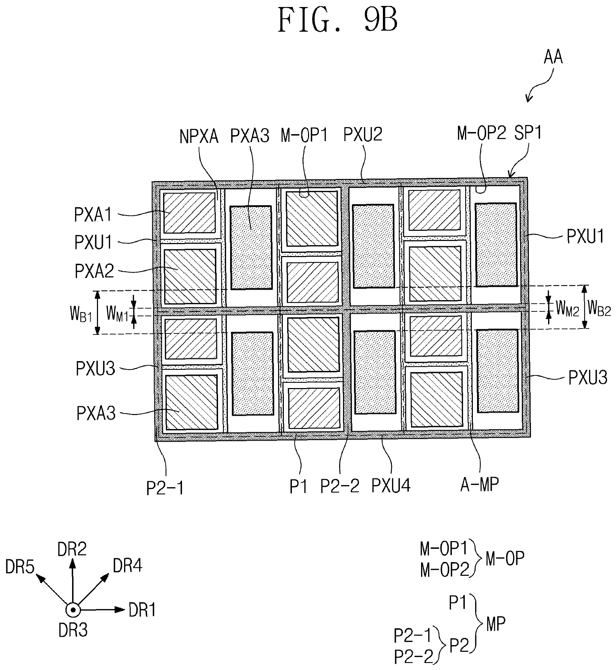

Referring to FIGS. 9A and 9B, a display device may further include an auxiliary mesh pattern A-MP included in a first sensor conductive layer (refer to MTL1 of FIG. 4C). The auxiliary mesh pattern A-MP may be electrically connected to a mesh pattern MP through a contact hole. The auxiliary mesh pattern A-MP may be located between light emitting areas PXA1, PXA2, and PXA3 when viewed in the plane. In this case, a resistance of the mesh pattern MP may be compensated. Since the auxiliary mesh pattern A-MP is located in the first sensor conductive layer (refer to MTL1 of FIG. 4C), the auxiliary mesh pattern A-MP may not affect characteristics of a light emitted from a display panel (refer to DP of FIG. 4C).

As shown in FIG. 9A, the distances in the second direction DR2 between third light emitting areas PXA3 may be different from each other, and as shown in FIG. 9B, the distances in the second direction DR2 between third light emitting areas PXA3 may be the same (or substantially the same) as each other.

Although aspects of some embodiments of the present invention have been described, it is understood that the present invention should not be limited to these embodiments but various changes and modifications can be made by one ordinary skilled in the art within the scope of embodiments according to the present invention as defined in the appended claims. Therefore, the disclosed subject matter should not be limited to any single embodiment described herein, and the scope of the present inventive concept shall be determined according to the attached claims.

## Claims

1. A display device (DD) comprising:
a display panel (DP) comprising a plurality of unit pixels (PXU1-PXU4) comprising a first unit pixel (PXU1) and a second unit pixel (PXU2) alternately arranged with the first unit pixel (PXU1) in a first direction (DR1); and
an input sensor (ISP) on the display panel (DP), the input sensor (ISP) comprising:
a first sensor conductive layer (MTL1) on the display panel (DP);
a first sensor insulating layer (ISL2) on the first sensor conductive layer (MTL1); and
a second sensor conductive layer (MTL2) on the first sensor insulating layer (ISL2),
wherein at least one of the first and second sensor conductive layers (MTL1, MTL2) is provided with a mesh opening (M-OP) defined therethrough,
each of the unit pixels (PXU1-PXU4) comprises a first light emitting area (PXA1) configured to emit a first color light, a second light emitting area (PXA2) configured to emit a second color light, and a third light emitting area (PXA3) configured to emit a third color light,
the first light emitting area (PXA1) of the first unit pixel (PXU1) and the second light emitting area (PXA2) of the second unit pixel (PXU2) are alternately arranged with each other in the first direction (DR1), and
the second light emitting area (PXA2) of the first unit pixel (PXU1) and the first light emitting area (PXA1) of the second unit pixel (PXU2) are alternately arranged with each other in the first direction (DR1).

2. The display device (DD) of claim 1,
wherein the first light emitting area (PXA1) of the first unit pixel (PXU1) and the second light emitting area (PXA2) of the second unit pixel (PXU2) are alternately arranged with each other with the third light emitting area (PXA3) interposed therebetween, and
the second light emitting area (PXA2) of the first unit pixel (PXU1) and the first light emitting area (PXA1) of the second unit pixel (PXU2) are alternately arranged with each other with the third light emitting area (PXA3) interposed therebetween.

3. The display device (DD) of claim 1 or 2,
wherein the first light emitting area (PXA1) is spaced apart from the second light emitting area (PXA2) in a second direction (DR2) perpendicular to the first direction (DR1) within the first unit pixel (PXU1),
the third light emitting area (PXA3) is spaced apart from the first and second light emitting areas (PXA1, PXA2) in the first direction (DR1) within the first unit pixel (PXU1),
the first light emitting area (PXA1) is spaced apart from the second light emitting area (PXA2) in a direction opposite to the second direction (DR2) within the second unit pixel (PXU2), and
the third light emitting area (PXA3) is spaced apart from the first and second light emitting areas (PXA1, PXA2) in the first direction (DR1) within the second unit pixel (PXU2).

4. The display device (DD) of at least one of claims 1 to 3,
wherein the display panel (DP) further comprises a third unit pixel (PXU3) alternately arranged with the first unit pixel (PXU1) in a second direction (DR2) perpendicular to the first direction (DR1) and a fourth unit pixel (PXU4) alternately arranged with the third unit pixel (PXU3) in the first direction (DR1),
the first light emitting area (PXA1) of the third unit pixel (PXU3) and the second light emitting area (PXA2) of the fourth unit pixel (PXU4) are alternately arranged with each other in the first direction (DR1), and
the second light emitting area (PXA2) of the third unit pixel (PXU3) and the first light emitting area (PXA1) of the fourth unit pixel (PXU4) are alternately arranged with each other in the first direction (DR1).

5. The display device (DD) of claim 4,
wherein the first light emitting area (PXA1) of the third unit pixel (PXU3) and the second light emitting area (PXA2) of the fourth unit pixel (PXU4) are alternately arranged with each other with the third light emitting area (PXA3) interposed therebetween, and
the second light emitting area (PXA2) of the third unit pixel (PXU3) and the first light emitting area (PXA1) of the fourth unit pixel (PXU4) are alternately arranged with each other with the third light emitting area (PXA3) interposed therebetween.

6. The display device (DD) of claim 4 or 5,
wherein the first light emitting area (PXA1) is spaced apart from the second light emitting area (PXA2) in the second direction (DR2) within the third unit pixel (PXU3),
the third light emitting area (PXA3) is spaced apart from the first and second light emitting areas (PXA1, PXA2) in the first direction (DR1) within the third unit pixel (PXU3),
the first light emitting area (PXA1) is spaced apart from the second light emitting area (PXA2) in a direction opposite to the second direction (DR2) within the fourth unit pixel (PXU4), and
the third light emitting area (PXA3) is spaced apart from the first and second light emitting areas (PXA1, PXA2) in the first direction (DR1) within the fourth unit pixel (PXU4).

7. The display device (DD) of at least one of claims 4 to 6, wherein a distance (W_{B1}) between the third light emitting area (PXA3) of the first unit pixel (PXU1) and the third light emitting area (PXA3) of the third unit pixel (PXU3) is different from a distance (W_{B2}) between the third light emitting area (PXA3) of the second unit pixel (PXU2) and the third light emitting area (PXA3) of the fourth unit pixel (PXU4).

8. The display device (DD) of at least one of claims 4 to 6, wherein a distance (W_{B1}) between the third light emitting area (PXA3) of the first unit pixel (PXU1) and the third light emitting area (PXA3) of the third unit pixel (PXU3) is equal to a distance (W_{B2}) between the third light emitting area (PXA3) of the second unit pixel (PXU2) and the third light emitting area (PXA3) of the fourth unit pixel (PXU4).

9. The display device (DD) of at least one of claims 4 to 8,
wherein the second sensor conductive layer (MTL2) is provided with the mesh opening (M-OP),
the second sensor conductive layer (MTL2) comprises a mesh pattern (MP) defining the mesh opening (M-OP),
the mesh pattern (MP) comprises a first line portion (P1) extending in the first direction (DR1) and a second line portion (P2) extending in the second direction (DR2), and the first line portion (P1) is between the first unit pixel (PXU1) and the third unit pixel (PXU3) and between the second unit pixel (PXU2) and the fourth unit pixel (PXU4) in a plan view.

10. The display device (DD) of claim 9, wherein a width of the first line portion (P1) and a width of the second line portion (P2) are not constant.

11. The display device (DD) of at least one of claims 4 to 8,
wherein the second sensor conductive layer (MTL2) is provided with the mesh opening (M-OP),
the second sensor conductive layer (MTL2) comprises a mesh pattern (MP) defining the mesh opening (M-OP),
the mesh pattern (MP) comprises a first line portion (P1) extending in the first direction (DR1) and a second line portion (P2) extending in the second direction (DR2),
the second line portion (P2) comprises a second-first line portion (P2-1) and a second-second line portion (P2-2) alternately arranged with the second-first line portion (P2-1) in the first direction (DR1),
the second-first line portion (P2-1) is at an edge of at least one of the first, second, third, and fourth unit pixels (PXU1-PXU4) in a plan view, and
the second-second line portion (P2-2) crosses over at least one of the first, second, third, and fourth unit pixels (PXU1-PXU4) in the plan view.

12. The display device (DD) of at least one of claims 1 to 11,
wherein the first sensor conductive layer (MTL1) comprises an auxiliary mesh pattern (A-MP), and
the auxiliary mesh pattern (A-MP) surrounds each of the first, second, and third light emitting areas (PXA1, PXA2, PXA3) in a plan view.

13. An electronic apparatus comprising:
the display device (DD) according to at least one of claims 1 to 12, comprising an active area (AA) and a peripheral area (NAA) adjacent to the active area (AA); and
a window (WM) on the display device (DD), wherein
the first unit pixel (PXU1) and the second unit pixel (PXU2) are located in the active area.
